# EUROPEAN PATENT APPLICATION

(11) **EP 0 818 806 A2**
(43) Date of publication of application: **14.01.1998**
(21) Application number: 97110373.4
(22) Date of filing: 25.06.1997
(51) Int. Cl.: H01L 21/00

(54) **Method and apparatus for transporting and using a semiconductor substrate carrier**

(30) Priority: 12.07.1996 US 680343
(71) Applicant: MOTOROLA, INC., Schaumburg, IL 60196 (US)
(72) Inventor: Mastroianni, Sal, Austin, Texas 78746 (US); Vasquez, Barbara, No. 112 Austin, Texas 78746 (US); Johnson, Barry, Austin, Texas 78759 (US)
(74) Representative: Hudson, Peter David

(57) **Abstract**

A carrier (200) having a side door (220) transports 300 millimeter semiconductor substrates (250) in a horizontal position. An airtight mini-environment is created by sealing mechanism (225) of the side door (220). Alignment features on the front of the carrier (440) and the process tool (430 align the carrier (440) to the tool (430). A gap (447) is formed between the carrier (440) and the tool (430 )when the carrier is attached to the carrier. The side door (445) is lowered into the tool (430) out of the transport path of the semiconductor substrates contained in the carrier (440). Airflow from the tool (430) to the intermediate environment (420) to the fabrication environment (410) is from a cleaner environment to a less clean environment.

## Description

### Field of the Invention

This invention relates generally to a carrier for a semiconductor substrate, and specifically to a semiconductor substrate carrier for a 300 millimeter (mm) semiconductor substrate.

### Background of the Invention

In the semiconductor arts, a semiconductor substrate carrier is a device capable of holding a plurality of semiconductor substrates during transportation. Semiconductor substrate carriers consist of a box and a cassette. The box is a container with a lid, which can be hinged. The cassette physically holds semiconductor substrates and fits in the box for transporting purposes. The cassette is removed from the box during a semiconductor processing step at a particular tool.

Cassettes used in modern semiconductor manufacturing facilities are capable of holding 25 semiconductor substrates, while carriers are capable of containing one or two cassettes. A number of disadvantages are associated with large lot sizes of 25 or 50 semiconductor substrates. One disadvantage being that as the number of semiconductor substrates associated with a given production lot increases the cycle time for completing that lot also increases. For example, some steps in the manufacturing of semiconductors take twice as long to process 50 semiconductor substrates as compared to 25. Therefore, cycle time is increased for large lots.

Another disadvantage of larger lot sizes is related to the risk and flexibility associated with manufacturing. For example, where the process lot size is the same as the transport lot size, if an event causes a lot to be destroyed, such as when a processing tool is operating out of a required range, the device loss from a large lot of semiconductor substrates is proportional to the number of semiconductor substrates in the lot. Also, large lot sizes reduce the flexibility of a manufacturing facility to support a wide range of semiconductor devices. As the number of devices available from a given lot increases, by either increasing lot sizes, shrinking device sizes, or increasing the semiconductor substrate size, the models used for production risk management and planning purposes need to change.

Ergonomic limits for human lift and carry pose yet another problem for large lot sizes. For frequent repetitive motions, 18 pounds is considered to be the upper weight limit which humans can safely handle. These repetitive functions are of a type as would be encountered in a semiconductor manufacturing facility. Within such a facility, carriers are lifted from transport devices or inventory storage areas and carried to a specific piece of processing equipment. Large lot sizes pose a risk by having increased weight from both added carrier size, and increased semiconductor substrate weight and count. Some studies indicate that a weight of 15 pounds is a more appropriate upper weight prevent to help limit problems associated with carpal tunnel syndrome. Therefore, as lot sizes and semiconductor substrate sizes increase, the additional weight poses health and safety considerations.

The need for clean environments in the semiconductor processing arts is well known. Present capabilities for providing cleaner environments allow for clean rooms rated at a M1 level. A class M1 clean room environment indicates that ten or fewer particles having a size of 0.5 microns (µm) or less, above a given size, reside in a cubic meter of air. The particle size allowed is dependent upon a minimum geometric feature of the semiconductor process being implemented. For example, if the minimum semiconductor feature size is one micron (µm), the particle size allowed for purposes of determining the clean room rating would be one third that feature size, or 0.33 µm. As minimum feature sizes become smaller, the need for improved clean room environments will increase past the sub-M1 rating.

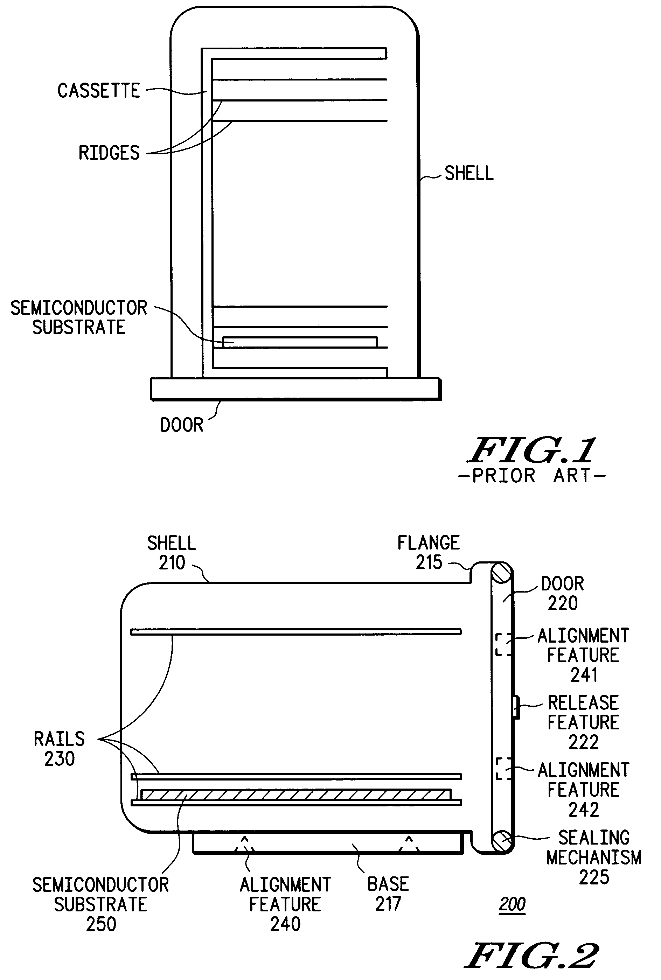

One known means of implementing a mini-environment is the Standard Mechanical Interface specification (SMIF). One implementation of SMIF maintains a mini-environment inside a bottom loading carrier. As illustrated in prior art FIG. 1, the bottom loading carrier pod has a carrier with an opening located at the bottom. When not engaging a specific piece of semiconductor equipment the carrier has a door covering the opening, such that it creates a seal with respect to the carrier. Within the pod, semiconductor substrates reside horizontally in a cassette which is separate from the carrier.

In order to access the enclosed semiconductor substrates, the carrier is placed upon a receptacle which removes the sealed mini-environment pod door and lowers door and semiconductor substrates into a tool environment where the semiconductor substrates can be further accessed. One problem associated with this type of carrier is that the mechanism which lowers the semiconductor substrates into the tool environment does so by lowering the pod door. This permits the outside of the door, which has been exposed to the relatively dirty manufacturing environment, to be lowered through the tool mini-environments where a stricter clean room standard is maintained. This allow contamination of the mini-environment.

An additional problem associated with the prior art as illustrated in FIG. 1, deals with ergonomic limits and the mounting of a pod containing a large number of semiconductor substrates on a tool. 900 mm is considered to be the height which humans can safely lift and mount a pod. As a result, in order for a tool to directly access all of the semiconductor substrates, it requires the cassette to be lowered completely into the tool. For operation from the 900 mm load height, this can result in there not being enough clearance for the mechanical mechanism lowering the door and cassette to operate without residing below floor level.

Therefore, a need exists to have a semiconductor substrate carrier capable of accessing semiconductor substrates in a mini-environment such that the processing equipment can access the semiconductor substrates directly upon removal of the door.

### Brief Description of the Drawings

FIG. 1 illustrates a prior art mini-environment carrier.

FIG. 2 illustrates a side view of mini-environment carrier in accordance with the present invention.

FIG. 3 illustrates a top view of mini-environment carrier in accordance with the present invention.

FIG. 4 illustrates a front view of mini-environment carrier in accordance with the present invention.

FIG. 5 illustrates a fabrication environment and tool using a mini-environment carrier in accordance with the present invention.

FIG. 6 illustrates a fabrication environment and tool using a mini-environment carrier in accordance with the present invention.

### Detailed Description of a Preferred Embodiment

In the semiconductor arts, the quest for increased devices in a cost efficient manner has been paramount. The common methods of increasing the number of devices efficiently has included reducing individual device sizes, increasing lot sizes, and increasing semiconductor substrate size.

Major conversions to larger semiconductor substrate sizes occurred from 100 mm semiconductor substrates, 150 mm semiconductor substrates, and on up to 200 mm semiconductor substrates. These conversions took full advantage of the increased device potential by maintaining previous lot sizes as semiconductor substrates diameters increase. As 300 mm semiconductor substrates become a reality, there are several considerations which make maintaining current lot sizes of 25 or 50 semiconductor substrates unattractive.

A first consideration is ergonomic in nature. A plastic semiconductor substrate carrier capable of holding 25 300 mm semiconductor substrates is estimated to weigh approximately 21 pounds. This weight is above a desired weight of no more than 15 pounds for frequent repetitive motion by a human operator, as found in a modern semiconductor facility. Therefore, an optimal lot size for ergonomic reasons is less than 25 semiconductor substrates.

In a fully automated fabrication facility, ergonomic considerations would not necessarily be a limitation. However, fully automated facilities do not provide the necessary flexibility needed by facilities which are not dedicated to a given product. This flexibility would include: the addition of new equipment; moving existing equipment, possibly for improved work flow as product mix changes; or for processing individual and mixed lots of semiconductor substrates which generally requires human intervention. For example, it may desirable for a manufacturer to build a low volume part in a 300 mm fabrication line. A twenty-five semiconductor substrate lot can produce several years worth of inventory. The cost associated with testing, packaging and maintaining inventory on several years worth of inventory is not practical. For reasons like these, flexibility is a requirement of many semiconductor facilities.

Cycle time is another important consideration in maintaining flexibility and reducing costs. The ability to quickly process semiconductor substrates allows for running a variety of products on single processing line, and quicker turn around for a given lot. Decreased cycle time also decreases costs associated with individual lots. Therefore, a shorter cycle time allows for more flexibility in product mix and product scheduling, as well as lower costs.

Another consideration against maintaining current lot sizes with semiconductor substrates larger than 200 mm addresses business considerations such as risk management and planning. Semiconductor manufacturers use various business models to plan, schedule, and budget semiconductor operation. Most of these models are optimized for 200 mm semiconductor substrates. Taken into account in these models are such items as the affect of a lot being destroyed, the number of devices needed to support production needs, the affect of running needed engineering test lots, and lead time to support production needs. By increasing semiconductor substrate sizes and maintaining existing lot sizes, these models would all change significantly.

The risk factor associated with the business considerations is significant with 300 mm semiconductor substrates. A 300 mm lot comprising twenty-five semiconductor substrates can produce a significant amount of product. If a single large lot were destroyed, the affect on business would be substantial. This factor, when taken into account in a cost model, causes an increase in risk/cost for devices from large lot sizes.

As discussed above, ergonomics, cycle time, risk management, product planning, and factory flexibility considerations make it undesirable to maintain the present lot size of twenty-five semiconductor substrates for 300mm wafers. It is estimated that from an ergonomic perspective that as many as approximately fifteen semiconductor substrates could reside in a single carrier without violating the fifteen pound goal. Therefore, ergonomic considerations dealing with weight set an upper limit on the number of wafers which can be manually moved in a flexible processing environment.

From a risk management, cycle time, planing and flexibility perspective, using fifteen 300 mm semiconductor substrates provides nearly 50% more devices than twenty-five 200 mm semiconductor substrates, based on the fact that a 300 mm semiconductor substrate has approximately 2.25 times the surface area of a 200 mm semiconductor substrate. Therefore, an optimal number would closely approximate the same amount of product as the previous twenty-five 200 mm semiconductor substrates provide. Theoretically, this works out to be between eleven and twelve 300 mm semiconductor substrates to provide approximately the same number of devices as twenty-five 200 mm semiconductor substrates. The need for a test semiconductor substrate, which is generally used to monitor the manufacturing processes, would suggest a preferred carrier size of thirteen 300 mm semiconductor substrates to support a production facility. A carrier size of thirteen is an estimated value, and the actual carrier size may vary from approximately ten to approximately fourteen semiconductor substrates.

The need for improved cleanliness of semiconductor substrate environments is also needed. For semiconductor feature sizes currently in manufacturing, a class M1 clean room is generally considered minimum. Because the implementation of feature sizes at the 0.25/0.18 µm level and the conversion to 300 mm semiconductor substrates are occurring at roughly the same time, environments capable of processing the semiconductor substrates in areas better than a class M1 clean room are needed. Contamination control in entire fabrication environments beyond the class M1 level for an entire fabrication floor will be very costly. Therefore, an alternative of using semiconductor facilities equipped with mini-environments designed for processing 0.25/0.18 µm technologies provides a preferred solution.

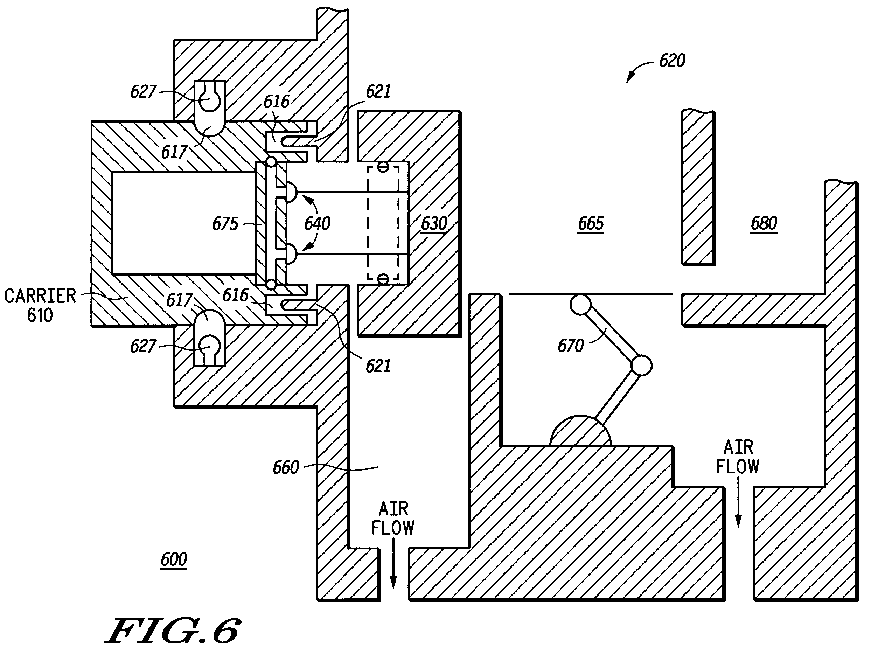

A mini-environment is an environment within a traditional clean room which itself is isolated from the larger clean room environment. A tool which performs a process on a semiconductor substrate may maintain its own internal clean environment such as interface chamber 435 (FIG. 5) or 665 (FIG. 6). This would be one example of a mini-environment, another would be the environment maintained by a semiconductor substrate carrier 200 which would be airtight from the surrounding environment. Therefore, as minimum feature sizes become smaller in the semiconductor arts, the need for improved clean room ratings is increased.

Preliminary information suggests that semiconductor substrate carrier mini-environments may achieve class M0.01, and can provide isolation two to three orders of magnitude improved over a surrounding environment. This suggests that factories with class M1 or better environment could be built and support mini environments to the M0.01 level. Because the cost of implementing a class M1 rated clean room facility is a small portion of facilitating a one billion dollar plus factory, it is also unlikely that ultra large scale integrated circuit facilities will be built with contamination control less clean than class M1. With semiconductor processing tools expected to be capable of maintaining class 0.01 mini-environment, the need for a semiconductor substrate carrier capable of maintaining the same quality will also be necessary.

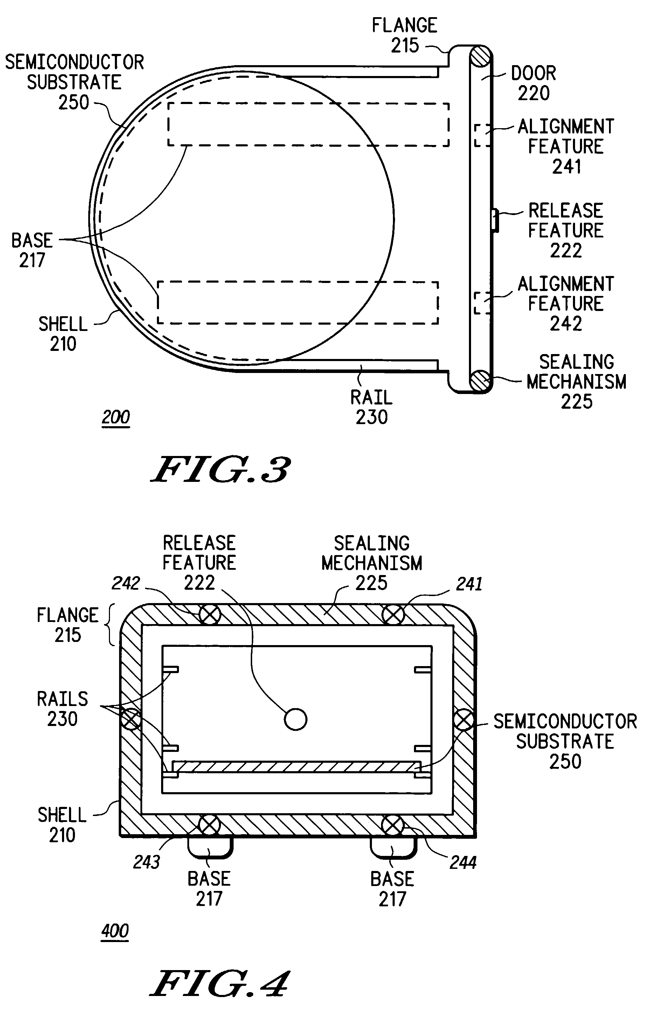

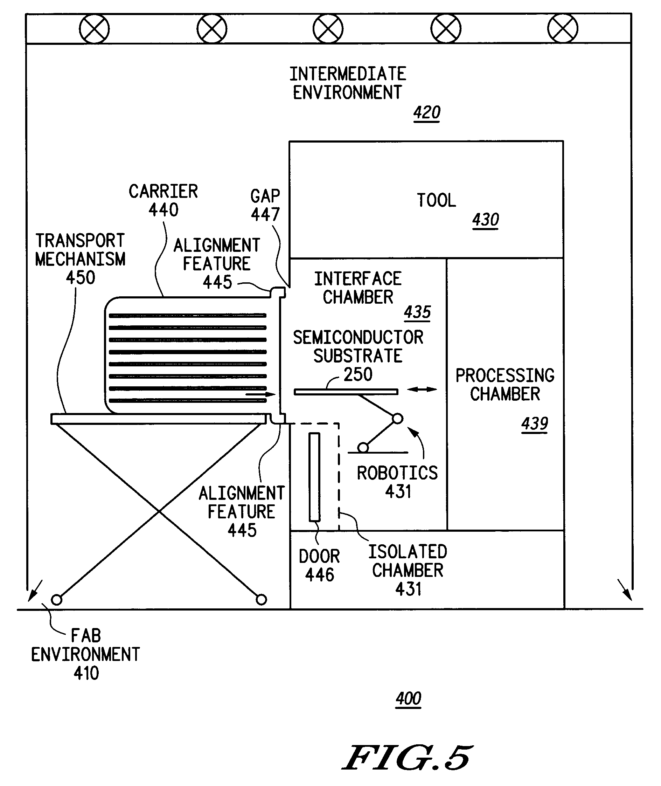

FIGs. 2, 3, and 4 illustrates different views of an integrated carrier in accordance with the present invention. The carrier 200 of FIG. 3 is an integrated carrier because a non-removable cassette is built into the carrier. Integrated carrier 200 comprises a shell 210, a shell base 217, and a side door 220.

In one embodiment of the invention, the shell 210 integrates the functions of the prior art shell and cassette. The shell 210 has a rectangular shape when viewed from the side, and has four substantially flat sides, one curved side, and forms an opening on a sixth side. The shell 210 has fourteen adjacent rails 230, or teeth, horizontally oriented for supporting thirteen individual 300 mm semiconductor substrates in a horizontal position during transport. A Horizontal plane is considered to be a plane substantially parallel to the floor of a fabrication facility. Note that the rail associated with a given horizontal plane may constitute one continuous rail (not shown), or a set of rails 230 capable of supporting the semiconductor substrates The plane formed by the opening of the shell 210 is vertical.

In an alternate embodiment, a shell and separate cassette (not shown) can be used. This embodiment would allow the cassette to be removed from the shell. The relational features discussed with reference to the integrated carrier also apply to the non-integrated carrier, unless noted otherwise.

The rails come in physical contact with the semiconductor substrates. In order to avoid static build up near the semiconductor substrates, the rails should include a static dissipative material to reduce the likelihood static charge accumulating on the substrates. Such materials include polypropilene, PEEK (poly ether ethea ketone), and polymers such as polycarbonate that may or may not contain fillers such as carbon fillers. Conversely, the shell 210 should have an outer surface which includes a static non-dissipative material such as ABS, polyethylene, polypropilene, and polycarbonate. This attracts small particles, serving as a particle scavenging surface to minimize the particle count on the semiconductor substrates. Between adjacent rails, slots exists from which semiconductor substrates may be inserted or removed horizontally. Three of the five sides and the opening of the shell 210 are oriented such that they are vertical relative to the horizontal plane created by a rail. The door 220 is located on a plane perpendicular to the semiconductor substrate orientation as defined by the rails. The shell 210 both protects and supports semiconductor substrates and allows access to the semiconductor substrates through the opening.

When viewed looking toward the opening of the shell 210, there is a flange 215 along the front edge of the shell 210. The front edge of the shell 210 is formed by a top surface, bottom surface, left surface, right surface of the shell 210. This constitutes the front surface of the shell 210. The flange is implemented such that it can interface with the shell 210 side door 220 and manufacturing tools.

The side door 220 is a removable door which resides at the shell 210 opening. In a preferred embodiment, it may reside within the confines of the flange, but is not so limited. The side door 220 fastens to the shell 210 such that an airtight mini-environment may be maintained within the carrier. This can be accomplished through the use of a mechanical cam type mechanism or by a bladder type system capable of being exercised by collapsing the bladder. A preferred side door 220 has a fail-closed bladder seal accessible to and opened by a single mechanism which collapses the seal by providing a vacuum or reduced pressure area on the inside of the bladder by using a rigid having a hollow portion. This interfaces to a release feature on the side door 220 which allowed access to a hollow area in the side door 220 which interfaced to the bladder. The tool then removes the side door 220 once the bladder is collapsed. The present invention is not intended to be limited by the mechanisms discussed, as it is understood that there may be numerous mechanisms capable of providing the seal and access to the shell 210. In addition, a preferred side door 220 is removable independent of the semiconductor substrates. For example, the side door 220 can be removed from the shell 210 without removal of the semiconductor substrates from the shell 210.

The support base provides support and a horizontal reference plane to the shell 210. The horizontal reference plane and the rails have lengths that are substantially parallel. The support base may be either an integral portion of the shell 210 body or a removable portion capable of detachment from the shell 210 body. An embodiment having no support base is possible, for example, where the flange associated with the shell 210 is missing or not below the bottom surface of the shell 210.

The carrier 200 has a side opening for receiving semiconductor substrates. The carrier 200 protects and supports semiconductor substrates. The semiconductor substrates are stored and transported in a horizontal position. The cassette 200 has several advantages over the known prior art. First, for substrates transported in a horizontal position, as opposed to a vertical traditional position, particle creation caused by semiconductor substrates shifting back and forth within the slots of a vertical carrier is reduced. Additionally, when carriers transporting and storing semiconductor substrates vertically are attached to tools or equipment, in order to be processed horizontally, they must have an orientation change. If done by rotating cassettes to a horizontal orientation, contaminates are introduced because pre-existing particulates are disturbed, and new particulates can be created from shifting of the semiconductor substrates against the carrier. With 0.25/0.18 µm processes, the sensitivity to particulates is increased over previous technologies with larger minimum feature sizes.

If cassettes transporting semiconductor substrates in a vertical position are used, then robotics which must lift the vertical semiconductor substrate beyond the carrier before presenting it to the tool are used. This requires more complex mechanisms. For a 300 mm semiconductor substrate, the height needed to clear a vertically transported semiconductor substrate would be even more prohibitive by requiring in excess of 600 mm from the carrier base to the top of the extracted a semiconductor substrate.

The present embodiment of the invention is beneficial over prior art horizontal transport systems, in that known prior art transport systems of plurality of semiconductor substrates in a mini-environments, were accessible only from a bottom plane. To dock a bottom-door carrier onto a processing tool, a robotics system capable of supporting three substantial axes of movement is required. In addition, such a method requires the contaminated door, which lowers the semiconductor substrates into the processing area, to reside in the same space as the semiconductor substrates. Even worse, the semiconductor substrates are continuously being lowered into the immediate area which was just previously occupied by the contaminated door. Therefore, the semiconductor substrates are being lowered through contaminated space. In an environment using a side door carrier, the side door can be removed in a vertical direction from the system, once clear from the carrier body (a short horizontal distance). This occurs in such a way that the semiconductor substrates do not follow the same path as the side door. In addition, the door can be moved to a separate area if desired, as may be needed to maintain a high degree of cleanliness. Not that in both side and bottom door opening systems, the outside of the carrier door mates with the outside of the tool port door. This pair of doors is then moved into the tool.

As previously mentioned, the carrier 200 needs to be interfaced to a tool. The carrier needs to have some alignment features to align the carrier being mounted to a processing tool. These alignment features can reside on a horizontal or vertical plane. For horizontal reference, the support base 330, can have a plurality of alignment features such as kinematic sockets, these kinematic sockets are used for alignment purposes in the processing of the semiconductor substrates. By putting alignment mechanisms on the support base 217, a horizontal reference plane alignment can be maintained. Alignment features may also be implemented on the front edge or vertical face of the carrier. This would allow a carrier to be transported and directly docked to the tool. This approach with alignment features on the vertical plane is equally compatible with delivery and docking of the carrier to the tool by an operator, by an human powered cart, or by robotic transport. Additionally, alignment features may be present on the side door itself (not shown).

In a preferred embodiment, it is the side of the carrier where the opening resides that mounts to the tool via alignment features. Once mounted, the carrier's weight could be supported by the carrier and tool alignment mechanisms 616 and 621, or by an external means such as a clamp 627 that is attached to both the tool 620 and the carrier 610. It is understood that many mechanisms of providing support may exist.

In one embodiment, the carrier 610 (FIG. 6) could be mounted to a tool by aligning alignment features 616 (FIG. 6) on the front of the carrier 200 to alignment features 621 near the port, or door, or the tool. Once mounted, the alignment features of the tool could support the entire weight of the carrier, a clamp 627 could support the weight of the carrier, or a transporting or other surface such as transport mechanism 450 could support the weight of the carrier 610.

In a preferred embodiment, the semiconductor substrates would be transported and mounted to tools in a horizontal position. However, the present invention would allow for the carrier 200 to be mounted such that the semiconductor substrates are oriented in a position other than horizontal, such as vertically.

When mounted in a preferred embodiment, there is a gap between the tool and the carrier. This gap allows air to flow between the tool environment and the fabrication environment (ambient region). The ability of air to flow between environments is useful in maximizing clean room environments. For example, if a tool maintains a class M0.01 environment, and the fabrication facility in which the tool resides is an M1 clean room environment, it would be beneficial for air to flow from the tool to the fabrication area in order to assure the tool environment is not contaminated to the surrounding level. The gap between the carrier and the tool would allow appropriate pressure differentials to be maintained. Conversely, if a tool performs a process which generates a large quantity of particulates, such as a probe function might create, it would be beneficial for air flow to be from the fabrication environment to the tool environment to prevent unnecessary contamination of the fabrication environment. This flow from clean to less clean areas is desirable. Generally, the gap between the tool and the facility will be approximately 10 mm or less and the pressure differential will have a magnitude difference of one pound per square inch (PSI) or less.

On the same topic, a gap may also exist between an intermediate or shrouded environment, such as a shrouded area in a manufacturing facility, and the facility itself. The gap would also allow air flow between the two environments. If the facility were cleaner than the intermediate environment, air flow would be from the intermediate environment to the facility from gap near the bottom of the intermediate environment. Conversely, if the facility were less clean, air flow would be from the intermediate environment to the facility. This would assure that contaminates near the floor of the more clean environment would not be disturbed upward through the intermediate environment. Generally, the gap between the intermediate environment and the facility will be approximately 10 mm or less, and the pressure difference between the intermediate environment, and the manufacturing facility will be approximately one PSI or less.

The method of operation could also include detecting relative levels of cleanliness and adjusting the flow of air such that the flow is from the less clean environment to the more clean environment

The tool 620 would generally have an interface chamber 665 and a processing chamber 680. The interface chamber 665 is an intermediate chamber where a robotics mechanism (not shown) is used to remove the side door 615 and transport 670 the semiconductor substrates (not shown in FIG. 6) from the carrier 610 to the processing chamber 680. Note that if a cassette is contained in the carrier 610, the entire cassette may need to be removed.

As discussed above, the side door 616 can be removed from in front of the opening of the carrier 610 and the tool port by engaging the side door 615 with the tool port door 630 and moving in a plane perpendicular to the semiconductor substrates without moving the semiconductor substrates. Moving the side door down to a side door/port chamber 660 would be a preferred embodiment, as it is desirable to remove the door 615 and port door 630 to a separate isolated area where any contaminates will not be allowed to Interact with the same environment that the semiconductor substrates are part of. This is an advantage over the prior art, in that the door 615 and port door 665 can be removed from the path that the semiconductor substrates use to engage a processing area of the tool. In another embodiment, a hinged door (not shown) that pivots down could be used.

The carrier 200 could be made of a number of various materials. Specifically, either a plastic, or metal carrier may be desirable. A plastic carrier would generally be preferred because it is less expensive, lighter, and potentially optically transparent as opposed to a metal carrier. Plastic does however have limitations in that there is limited ability to create a vacuum within the mini-environment, and outgassing of plastic materials occur. A metal carrier 200, while being more expensive and heavier, would allow for a vacuum mini-environment. In either event, whether plastic, or metal, a substantially air-tight environment within the carrier capable of maintaining the increased class clean environment is possible.

In the forgoing specification, the invention has been described with reference to specific embodiments. However, one of ordinary skill in the art appreciates that various modifications and changes can be made without departing from the scope of the present invention as set forth in the claims below. Accordingly, the specification and figures are to be regarded in an illustrative rather than a restrictive sense, and all such modifications are intended to be included within the scope of the present invention. In the claims, means-plus-function clause(s) , if any, cover the structures described herein that perform the recited functions. The mean-plus-function clause(s) also cover structural equivalents and equivalent structures that perform the recited function(s).

## Claims

1. An apparatus comprising:
a tool (430) including:
a wall having an alignment feature;
an interior region (435); and
a port that is capable of moving primarily vertically within the tool (430); and
a semiconductor substrate carrier (440) capable of carrying a plurality of semiconductor substrates (250), wherein the semiconductor substrate carrier (440) is mounted to the tool (430) near the port and outside of the interior region (435) wherein there is a gap (447) between the tool (430) and the carrier (440).

2. The apparatus of claim 1, wherein the semiconductor substrate carrier (440) further comprises:
a shell (210);
a plurality of rails (230 );
a plurality of slots, wherein each slot of the plurality of slots lies between adjacent rails of the plurality of rails (230); and
a carrier door (220, 446), wherein the carrier door (220, 446) that is part of a side of the semiconductor substrate carrier (440) and has a primary surface substantially perpendicular to length of the slots.

3. The apparatus of claim 2, wherein the semiconductor substrate carrier (440) is an integrated carrier.

4. The apparatus of claim 2, wherein:
the plurality of rails (230) includes a static dissipative material; and
the shell (210) includes a static nondissipative material.

5. A method of processing a semiconductor substrate comprising the steps of:
providing a tool (430) including a wall and a port adjacent to the wall;
placing a semiconductor substrate carrier (440) that has a carrier door (220, 446) and the semiconductor substrate onto a platform near the wall of the tool (430);
moving the semiconductor substrate carrier (440) such that the carrier door (220, 446) lies near the port;
engaging the carrier door (220, 446) with the tool (430), wherein a gap (447) is maintained between the semiconductor substrate carrier (440) and the wall of the tool (430);
moving the carrier door (220, 446) out of a plane of semiconductor substrate transport; and
accessing the semiconductor substrate (250).

6. The method of claim 5, wherein the step of placing the semiconductor substrate carrier (440) onto the platform is performed such that:
each of the semiconductor substrate carrier (440) and the platform further comprises an alignment feature; and
the alignment features are used to align the semiconductor substrate carrier (440) to the platform.

7. The method of claim 5, wherein:
the step of providing the tool (430) is performed such that the tool (430) includes an interior region lying adjacent a side of the wall of the tool (430) and an ambient region lies adjacent an opposite side of the wall of the tool (430); and
the method further comprises steps of:
comparing a relative cleanliness of the interior region and an ambient region, wherein the ambient region lies on an opposite side of the wall compared to the interior region to determine which of the interior region and ambient region is a more clean region and which of the interior region and ambient region is a less clean region; and
adjusting a gas flow of a gas through the gap (447) such that the gas flows from the more clean region to the less clean region.

8. A method of processing a semiconductor substrate comprising the steps of:
providing a tool (430) including a wall having a port, and an alignment feature adjacent to the wall;
providing a semiconductor substrate carrier (440) that has a carrier door (220, 446), an alignment feature, and the semiconductor substrate;
aligning the semiconductor substrate carrier (440) to the wall of the tool (430) using the alignment features of the semiconductor substrate carrier (440) and the wall, wherein a gap (447) is maintained between the semiconductor substrate carrier (440) and the wall of the tool (430);
moving the carrier door (220, 446) out of a plane of substrate transport; and
accessing the semiconductor substrate.

9. The method of claim 8, wherein:
the step of providing the tool (430) is performed such that the tool (430) includes an interior region lying adjacent a side of the wall of the tool (430) and an ambient region lies adjacent an opposite side of the wall of the tool (430); and
the method further comprises steps of:
comparing a relative cleanliness of the interior region and an ambient region, wherein the ambient region lies on an opposite side of the wall compared to the interior region to determine which of the interior region and ambient region is a more clean region and which of the interior region and ambient region is a less clean region; and
adjusting a gas flow of a gas through the gap (447) such that the gas flows from the more clean region to the less clean region wherein thereis a pressure differential between the more clean region and the less clean region and the pressure differential is no more than one pound per square inch.

10. The method of claim 5/8, further comprising a step of removing a cassette from the semiconductor substrate carrier (440) after the step of moving the carrier door (220, 446), wherein moving the carrier door (220, 446) moves the carrier door (220, 446) to a lower elevation, but does not move the semiconductor substrate to a lower elevation.

11. A method of processing a semiconductor substrate comprising the steps of:
providing a tool (430) having a wall, a port lying adjacent to the wall, and an interior region adjacent to a side of the wall, wherein an ambient region adjacent to an opposite side of the wall;
placing the semiconductor substrate adjacent to the wall and port such that a gap (447) is maintained between the semiconductor substrate and the wall and the port;
comparing a relative cleanliness of the interior region and an ambient region to determine which of the interior region and ambient region is a more clean region and which of the interior region and ambient region is a less clean region; and
adjusting a gas flow of a gas through the gap (447) such that the gas flows from the more clean region to the less clean region.

12. The method of claims 5, 8 and 11, wherein the step of placing is performed such that the gap (447) is no greater than 10 mm.

13. A method of processing a semiconductor substrate comprising the steps of:
providing a tool (430, 620) having:
a first wall and a first port lying adjacent to the first wall, and a first wall gap;
a second wall, a second port lying adjacent to the second wall, and a second wall gap (447) lying adjacent to the second wall;
a first interior region (680) and a second interior region (665), wherein:
the second interior region (665) lies between the first and second walls;
the first interior region (680) lies adjacent to a side of the first wall opposite the side adjacent to the second interior region; and
an ambient region lies outside the tool (430) adjacent to a side of the second wall opposite the side adjacent to the second interior region;
placing the semiconductor substrate adjacent to the first wall of the tool (430) such that a first wall gap (447) is maintained between the semiconductor substrate carrier (440) and the first wall;
comparing the relative cleanliness of the first interior region (680), second interior region (665), and the ambient region to determine which of three regions is a most clean region, an intermediate clean region, and a least clean region; and
adjusting gas flows through the first and second gap (447) to form a gas flow pattern selected from:
from the most clean region to the least clean region;
from the most clean region to the intermediate clean region; and
from the intermediate clean region to the least clean region.
